Europäisches Patentamt

European Patent Office

Office européen des brevets

(19)

(11) **EP 0 730 162 A2**

(12) **EUROPÄISCHE PATENTANMELDUNG**

(43) Veröffentlichungstag:
04.09.1996 Patentblatt 1996/36

(51) Int. Cl.⁶: **G01R 33/09**

(21) Anmeldenummer: 96102482.5

(22) Anmeldetag: 19.02.1996

(84) Benannte Vertragsstaaten:
**AT CH DE FR GB IT LI**

(30) Priorität: **02.03.1995 DE 19507303**

(71) Anmelder: **SIEMENS AKTIENGESELLSCHAFT**
**80333 München (DE)**

(72) Erfinder: **van den Berg, Hugo, Dr.**
**D-91074 Herzogenaurach (DE)**

(54) **Sensoreinrichtung mit einer Brückenschaltung von magnetoresistiven Sensorelementen**

(57) Die Sensoreinrichtung weist eine Brückenschaltung von magnetoresistiven Sensorelementen ($E_1$ bis $E_4$) auf. Jedes Sensorelement ($E_1$ bis $E_4$) soll den gleichen Schichtaufbau besitzen und auf einem gemeinsamen Trägerelement (T) angeordnet sein. Dabei soll mindestens eines der Sensorelemente ($E_1$, $E_4$) eine gegenüber den anderen Sensorelementen ($E_2$, $E_3$) unterschiedliche Empfindlichkeit bzgl. seines magnetoresistiven Effektes besitzen, indem es eine abweichende Geometrie bzw. Grundfläche ($F_a$) aufweist. Dieses mindestens eine Sensorelement ($E_1$, $E_4$) unterschiedlicher Empfindlichkeit kann insbesondere einen sehr großen magnetoresistiven Effekt (GMR) zeigen. Es kann vorteilhaft aus einzelnen, mäanderförmig hintereinandergeschalteten streifenförmigen Teilelementen zusammengesetzt sein.

FIG 1

EP 0 730 162 A2

**Beschreibung**

Die Erfindung bezieht sich auf eine Sensoreinrichtung zur Erfassung eines äußeren zumindest weitgehend homogenen Magnetfeldes mit einer Brückenschaltung von magnetoresistiven Sensorelementen mit Dünnschichtaufbau, die in zwei zwischen Anschlußpunkten für einen über die Brückenschaltung zu führenden Strom parallelgeschalteten Brückenzweigen angeordnet sind. Eine derartige Sensoreinrichtung ist in dem DE-GBM 93 12 674.3 angedeutet.

In ferromagnetischen Übergangsmetallen wie Ni, Fe oder Co und deren Legierungen ist der elektrische Widerstand von der Größe und der Richtung eines das Material durchdringenden Magnetfeldes abhängig. Diesen Effekt nennt man anisotropen Magnetowiderstand (AMR) oder anisotropen magnetoresistiven Effekt. Er beruht physikalisch auf den unterschiedlichen Streuquerschnitten von Elektronen mit der Spinpolarität des D-Bandes mit unterschiedlichem Spin, die entsprechend als Majoritäts- bzw. Minoritätselektronen bezeichnet werden. Für magnetoresistive Sensoreinrichtungen wird im allgemeinen eine dünne Schicht aus einem solchen magnetoresistiven Material mit einer Magnetisierung in der Schichtebene verwendet. Die Widerstandsänderung bei Drehung der Magnetisierung bezüglich der Stromrichtung kann einige Prozent des normalen isotropen (ohmschen) Widerstandes betragen (vgl. das eingangs genannte DE-GBM).

Ferner sind seit einiger Zeit magnetoresistive Mehrschichtsysteme bekannt, welche mehrere, zu einem Stapel angeordnete ferromagnetische Schichten enthalten, die durch metallische Zwischenschichten voneinander getrennt sind und deren Magnetisierungen jeweils in der Schichtebene liegen. Die jeweiligen Schichtdicken sind dabei deutlich geringer als die mittlere freie Weglänge der Leitungselektronen gewählt. In solchen Mehrschichtsystemen kann nun zusätzlich zu dem erwähnten anisotropen magnetoresistiven Effekt (AMR) in den einzelnen Schichten ein sogenannter giant-magnetoresistiver Effekt oder Giant-Magnetowiderstand (GMR) auftreten (vgl.z.B. EP-A-0 483 373). Ein solcher GMR-Effekt beruht auf der unterschiedlich starken Streuung von Majoritäts- und Minoritäts-Leitungselektronen an den Grenzflächen zwischen den ferromagnetischen Schichten und den Zwischenschichten sowie auf Streuungen innerhalb der Schichten insbesondere bei Verwendung von Legierungen. Der GMR-Effekt ist ein isotroper Effekt. Er kann erheblich größer sein als der anisotrope Effekt AMR und kann Werte bis zu 70 % des normalen isotropen Widerstandes annehmen. In den einen GMR-Effekt zeigenden Mehrschichtsystemen sind benachbarte metallische Magnetschichten zunächst entgegengesetzt magnetisiert. Unter dem Einfluß eines äußeren Magnetfeldes kann sich die antiparallele Ausrichtung der Magnetisierungen in eine parallele umwandeln. In entsprechenden Sensoreinrichtungen wird diese Tatsache ausgenutzt.

Aus dem eingangs genannten DE-GBM ist eine Sensoreinrichtung bekannt, mit deren Sensorelementen, die einen anisotropen Magnetowiderstand AMR zeigen, eine Brückenschaltung aufgebaut werden kann. Bei dieser Sensoreinrichtung wird gezielt die Tatsache ausgenützt, daß in den einzelnen Sensorelementen das Vorzeichen der AMR-Widerstandsänderung von der Richtung des Stromes abhängig ist.

Aufgabe der vorliegenden Erfindung ist es, die Sensoreinrichtung mit den eingangs genannten Merkmalen dahingehend auszugestalten, daß mit ihr eine Vektorkomponente eines in dem Empfangsbereich der Sensoreinrichtung zumindest weitgehend homogenen Magnetfeldes mit hoher Empfindlichkeit zu messen ist, wobei das Meßsignal zumindest weitgehend hinsichtlich von Temperatureinflüssen und mechanischen Spannungen der Brückenelemente kompensiert ist. Außerdem soll die Sensoreinrichtung verhältnismäßig einfach herzustellen sein.

Diese Aufgabe wird erfindungsgemäß dadurch gelöst, daß alle Sensorelemente mit demselben Schichtaufbau auf einem gemeinsamen Trägerelement ausgebildet sind und daß ferner mindestens eines der Sensorelemente eine gegenüber den anderen Sensorelementen abweichende Empfindlichkeit bezüglich seines magnetoresistiven Effektes besitzt, indem dieses mindestens eine Sensorelement mit der abweichenden Empfindlichkeit eine von den anderen Sensorelementen abweichende Geometrie auf dem Trägerelement aufweist.

Die mit dieser Ausgestaltung der Sensoreinrichtung verbundenen Vorteile sind insbesondere darin zu sehen, daß sich mit der Brückenschaltung der Brückenelementen ein temperaturkompensiertes Meßsignal in Abhängigkeit von einem äußeren Magnetfeld erhalten läßt, das auch bezüglich mechanischer Spannungen der Brückenelemente zumindest teilweise kompensiert ist. Dies läßt sich auf einfache Weise durch die unterschiedlichen Größen (Geometrien) der Brückenelemente sowie durch ihren gleichen Schichtaufbau nebeneinander auf einem gemeinsamen Trägerelement erreichen. Unter einem Schichtaufbau einer erfindungsgemäßen Sensoreinrichtung sei dabei verstanden, daß jedes Sensorelement entweder eine einzelne Schicht mit jeweils gleicher Dicke oder eine vorbestimmte Schichtenfolge eines Schichtenstapels mit vorbestimmter Dicke der einzelnen Schichten aufweist. Die Schichtenfolge und die Dicken sich entsprechender Schichten sind dann in einem solchen Schichtenstapel für alle Brückenelemente gleich. Im Gegensatz zu der bekannten Sensoreinrichtung mit AMR-Sensorelementen, wo die Empfindlichkeit über deren Stromrichtungsempfindlichkeit ausgenützt ist, wird bei der erfindungsgemäßen Sensoreinrichtung vorteilhaft einfach eine Empfindlichkeitseinstellung über die Geometrie der einzelnen Elemente erreicht. Für die Sensorelemente einer erfindungsgemäßen Sensoreinrichtung kommen an sich alle bekannten Typen von Elementen mit magnetoresistivem Effekt in Frage; besonders vorteilhaft werden jedoch Sensorelemente mit Schichtenfolgen verwendet, die einen großen magnetoresistiven Effekt (GMR) zeigen können.

Vorteilhafte Ausgestaltungen der erfindungsgemäßen Sensoreinrichtung gehen aus den sich dem Hauptanspruch unterordnenden Ansprüchen hervor.

Zur weiteren Erläuterung der Erfindung wird nachfolgend auf die Zeichnung Bezug genommen. Dabei zeigen jeweils schematisch

Figur 1      das Schaltbild einer Brückenschaltung einer ersten erfindungsgemäßen Sensoreinrichtung,

Figur 2      das Schaltbild einer Brückenschaltung einer zweiten erfindungsgemäßen Sensoreinrichtung

und

Figur 3 und Figur 4      jeweils eine Ausbildungsmöglichkeit eines Sensorelementes dieser erfindungsgemäßen Sensoreinrichtungen.

In den Figuren sind sich entsprechende Teile mit denselben Bezugszeichen versehen.

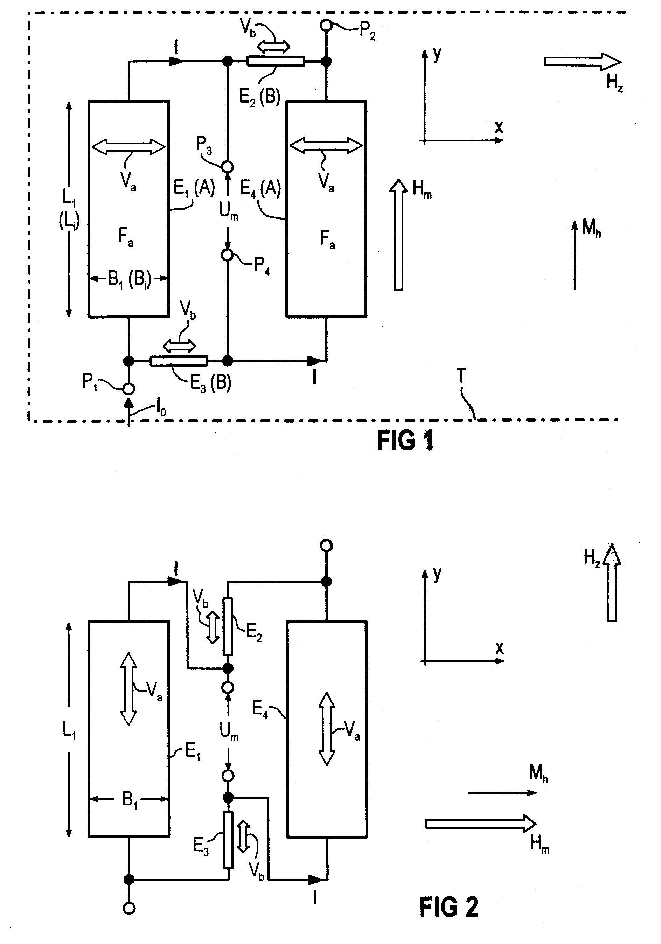

Eine Sensoreinrichtung nach der Erfindung weist entsprechend Figur 1 eine Brückenschaltung (Wheatstone-Brücke) auf, die zwei zwischen zwei Anschlußpunkte $P_1$ und $P_2$ der Brücke parallelgeschaltete Brückenzweige aufweist. Über die Brücke soll an den Anschlußpunkten ein Strom $I_o$ geführt werden, so daß in den einzelnen Brückenzweigen dann ein Strom $I$ fließt. Der Strom $I_o$ braucht nicht unbedingt konstant gehalten zu werden. Jeder Brückenzweig enthält mindestens zwei in Reihe geschaltete Brückenelemente $E_1$, $E_2$ bzw. $E_3$, $E_4$. Zwischen den beiden Elementen jeden Brückenzweiges liegt ein Meßpunkt $P_3$ bzw. $P_4$ der Brücke. An diesen Meßpunkten kann eine Meßspannung $U_m$ abgenommen werden.

Die einzelnen Brückenelemente der Brückenschaltung sollen vorzugsweise aus an sich bekannten Mehrschichtsystemen mit GMR-Effekt aufgebaut werden (vgl. z.B. die genannte EP-A 0 483 373 oder die DE-OSen 42 32 244, 42 43 357 oder 42 43 358). Bei solchen Mehrschichtsystemen ist der spezifische Widerstand $\rho$ abhängig von dem Winkel $\phi$ zwischen den Magnetisierungsrichtungen aufeinanderfolgender ferromagnetischer Schichten. Dieser Widerstand kann in zwei Anteile zerlegt werden, einen vom Winkel $\phi$ unabhängigen Anteil $\rho_0$, der bei einer parallelen Ausrichtung der Magnetisierungen erhalten wird, und einen winkelabhängigen Anteil $\Delta\rho$. In empfindlichen Systemen beträgt $\Delta\rho$ typischerweise 15 bis 30 % von $\rho_0$. Es zeigt sich jedoch, daß sowohl $\rho_0$ wie in geringem Umfang $\Delta\rho$ eine Abhängigkeit von der Betriebstemperatur $T_b$ besitzen. So ist bei Raumtemperatur $T_a$ das $\rho_0$, das von einem stark temperaturabhängigen Beitrag der Phononen und Magnonen geprägt ist, annähernd proportional zu $T_b/T_a$. Das bedeutet z.B., daß bei einer Temperaturerhöhung um 50°C über $T_a$ sich eine Änderung von $\rho_0$ um etwa 17 % ergibt. Eine solche Änderung ist für die meisten Anwendungen inakzeptabel. Andererseits ist die Temperaturabhängigkeit von $\Delta\rho$ materialabhängig, wobei sie z.B. für Fe größer ist als für Ni oder Co. Verglichen zu $\rho_0$ ist jedoch diese Abhängigkeit von $\Delta\rho$, das im wesentlichen durch Streuungen an Gitterdefekten hervorgerufen wird, verhältnismäßig gering. Außerdem führen mechanische Verspannungen entsprechender Sensorelemente zu einer $\rho_0$-Änderung und könnten irrtümlich als Beitrag zu $\Delta\rho$ aufgefaßt werden.

Die Erfindung geht nun von der Überlegung aus, daß mit einer Brückenschaltung eine Trennung der Summanden $\rho_0$ und $\Delta\rho$ des spezifischen Widerstandes $\rho$ derart möglich ist, daß eine Abhängigkeit der an den Meßpunkten der Brückenschaltung in der Mitte jedes Brückenzweiges abzunehmenden Meßspannung $U_m$ praktisch nur noch von $\Delta\rho$ besteht. Voraussetzung hierzu ist, daß sich das mindestens eine Brückenelement mit GMR-Effekt praktisch nur hinsichtlich dieses Summanden $\Delta\rho$, der auf Streueffekte an Gitterdefekten zurückzuführen ist, von den anderen Elementen der Brücke unterscheidet. Da $\Delta\rho$ nur wenig temperaturabhängig ist, läßt sich so mit der Brückenschaltung vorteilhaft ein entsprechend temperatur- und spannungskompensiertes Meßsignal in Abhängigkeit von einem äußeren Magnetfeld erhalten. Hierzu müssen sich alle Brückenelemente auf einem gemeinsamen Tragerelement (Substrat) befinden. Dieses Trägerelement ist in Figur 1 nur durch eine gestrichelte Linie angedeutet und mit T bezeichnet. Es besteht z.B. aus Silizium.

Ein entsprechender Aufbau einer Sensoreinrichtung nach der Erfindung ist bei der in Figur 1 gezeigten Brückenschaltung zugrundegelegt. Dabei sind noch folgende Bezeichnungen gewählt, nämlich

$E_i$ (mit i = 1, 2, 3 oder 4) für die Sensorelemente,
$B_i$ für die Breite des Sensorelementes $E_i$ quer zur Stromführungsrichtung,
$L_i$ für die Länge des Sensorelementes $E_i$,
$H_m$ für die Feldstärke eines zu messenden Magnetfeldes,
$M_h$ für die Magnetisierung von hartmagnetischen Biasschichten der Sensorelemente,
$H_z$ für die Feldstärke eines zusätzlichen Biasfeldes,
$V_a$, $V_b$ für magnetische Vorzugsachsen von Meßschichten der Sensorelemente,
$F_a$, $F_b$ für die Grundflächen der Brückenelemente,
x, y für die Koordinaten eines rechtwinkligen Koordinatensystems.

Alle Sensorelemente $E_i$ haben dabei erfindungsgemäß denselben Schichtaufbau (Schichtenfolge) mit gleicher Schichtdicke entsprechender Schichten, wobei für das Ausführungsbeispiel angenommen sei, daß jedes Sensorelement mindestens ein Schichtpaket aus einer hartmagnetischen Biasschicht oder aus einem Biasschichtsystem (mit der Magnetisierung $M_h$) und eine weichmagnetische Meßschicht mit dazwischen befindlicher Zwischenschicht zur weitgehenden Entkopplung der beiden Schichten aufweist (vgl. z.B. DE-OS 42 32 244). Im allgemeinen wird der Schichtaufbau jedes Sensorelementes aus einem Stapel entsprechender Schichtpakete bestehen. Ferner sei angenommen, daß jeweils zwei Sensorelemente aus verschiedenen Brückenzweigen gleiche Grundflächen haben, so daß die Sensorelemente in zwei Gruppen A und B einzuteilen sind. Dabei sind der Gruppe A die Sensorelemente $E_1$ und $E_4$ und der Gruppe B die Sensorelemente $E_2$ und $E_3$ zugeordnet. Die Elemente der Gruppe A besitzen dabei eine wesentlich größere, vorzugsweise mindestens 10-mal größere Grundfläche $F_a$ als die Elemente der Gruppe B mit der Grundfläche $F_b$. Die Grundflachen $F_b$ sind dabei so klein gewählt, daß die Sensorelemente $E_2$ und $E_3$ praktisch keinen magnetoresistiven Effekt, sondern nur ein weitgehend ohmsches Widerstandsverhalten zeigen. Die die einzelnen Grundflächen festlegenden Größen $L_i$ und $B_i$ sollen dabei eine in Stromführungsrichtung gesehen langgestreckte Gestalt der einzelnen Sensorelemente $E_i$ gewährleisten. Deshalb muß $L_i \geq 2 * B_i$ sein.

Im Grundzustand beispielsweise bei fehlendem äußeren Feld $H_m$ $(= 0)$ sind vorteilhaft alle Widerstände $R_a = R_b = R$ gleich groß, d.h., der Quotient $L_i/B_i$ ist für alle Elemente gleich. $R_a$ und $R_b$ sind dabei die ohmschen Widerstände der Elemente $E_1$ und $E_4$ der A-Gruppe bzw. der Elemente $E_2$ und $E_3$ der B-Gruppe. Die Elemente der Gruppe A lassen sich verhältnismäßig leicht sättigen, während das entmagnetisierende Feld bei den Elementen der Gruppe B eine große Drehung der Magnetisierung im Meßbereich verhindert. Das bedeutet, daß die Empfindlichkeit der Elemente der Gruppe B möglichst klein ist und diese Elemente quasi als ohmsche Elemente angesehen werden können. Für die Suszeptibilität $\chi_b = d M_y/d H_m$ der B-Elemente $E_2$ und $E_3$ gilt dann, wobei die nachfolgende Betrachtung im cgs-System erfolgt:

$$\chi_b = B_b/d_m/(4\pi) \text{ für } |H_m| \leq 4\pi M_b d_m / B_b. \tag{1}$$

Der Index b ist dabei wegen der Betrachtung der Elemente der Gruppe B gewählt; (analog wird nachfolgend der Index a für die A-Elemente verwendet). In Gleichung (1) ist $d_m$ die Gesamtdicke aller Meßschichten des Schichtaufbaus eines Sensorelementes. Wünscht man sich eine lineare Sensorkennlinie und eine hohe Empfindlichkeit, dann ist es vorteilhaft, in den Meßschichten eine uniaxiale Vorzugsachse $V_a$ quer zur Längsrichtung der A-Elemente aufzuprägen und die Magnetisierung $M_h$ der Biassysteme senkrecht hierzu einzustellen (vgl. die genannte DE-OS 42 32 244). Mit einer Anisotropiekonstanten K und $K > 2\pi M_m^2 * d_m/B_a = K_{mag}$ wird die Suszeptibilität $\chi_a$ der A-Elemente gleich:

$$\chi_a = M_m^2 / 2(K - 2\pi M_m^2 d_m/Ba) \tag{2}$$

für $|H_m| \leq 2 (K - 2\pi M_m^2 d_m/B_a)/M_m$

In diesem Fall ändert sich auch $\chi_b$ und Gleichung (1) muß ersetzt werden durch:

$$\chi_b = M_m^2 / 2(K + 2\pi M_m^2 d_m/B_b) \tag{3}$$

für $|H_m| \leq 2(K + 2\pi M_m^2 d_m/B_b)/M_m$

Für die Empfindlichkeit der Brückenschaltung $(dU_m/dH_m)/I_o$ gilt dann:

$$(dU_m/dH_m)/I_o = d\{(\Delta R_a + R_a - \Delta R_b - R_b)/2\} / dH_m, \tag{4a}$$

mit $R_a = R_b = R$
so daß sich ergibt:

$$(dU_m/dH_m)/I_o = d \{(\Delta R_a - \Delta R_b)/2\} / dH_m, \tag{4b}$$

$$= R /(2\rho) \Delta\rho_{max} (\chi_a - \chi_b)/M_m, \tag{4c}$$

$$= R / (4\rho) \Delta\rho_{max} M_m ** \left\{ \frac{1}{K - 2\pi M_m^2 d_m / B_a} - \frac{1}{K + 2\pi M_m^2 d_m / B_b} \right\}. \tag{4d}$$

Aus Gleichung (4c) läßt sich ablesen, daß die Brückenempfindlichkeit am größten ist, wenn die Suszeptibilität $\chi_b$ der B-Elemente möglichst klein ist im Vergleich zur Suszeptibilität $\chi_a$ der A-Elemente. Dieses Verhältnis $\chi_a/\chi_b$ läßt sich abschätzen unter Annahme der folgenden Größen: $K = 10^4$ erg/cm$^2$; $M_m = 10^3$; $d_m = 50$ nm, $B_a = 50$ µm und $B_b = 2$

μm. Dann beträgt dieses Verhältnis ungefähr $16 * 10^4/0{,}4 * 10^4 = 40$. Dies bedeutet einen Signalverlust der B-Elemente von nur 1/40. Erreicht worden ist dies durch das Breitenverhältnis der Elemente $B_a/B_b$ (= 10) und durch die Erhöhung der Empfindlichkeit der A-Elemente, indem die uniaxiale Vorzugsachse $V_a$ senkrecht zur Längsrichtung der A-Elemente gewählt worden ist. Hierdurch ist der Nenner "$K - 2\pi M_m^2 d_m/B_a$" von $\chi_a$ in Gleichung (2) von $K = 10^4$ auf $4 * 10^3$ erg/cm² zurückgegangen. Dieser letztere Gewinn ist über die Breite $B_a$ und den Betrag von K einstellbar. Der K-Variationsbereich ist beschränkt, weil die Meßschichten weichmagnetisch sein sollen. Auch ist der Variationsbereich von $B_a$ nicht beliebig, weil der Gesamtwiderstand des Sensorelementes einen gewissen Mindestwert haben soll und seine Grundfläche aus Kosten- und Ortsauflösungsgründen einen Maximalwert nicht überschreiten kann. In den nachfolgenden Ausführungsformen wird aufgezeigt, wie man diesen manchmal entgegengesetzten Anforderungen gerecht werden kann.

Zur Unterdrückung der Ausbildung von Domänen wird zusätzlich ein Biasfeld $H_z$ angelegt. Gemäß dem Ausführungsbeispiel nach Figur 1 steht dieses Feld parallel zur Magnetisierung im Grundzustand sowohl von den A-Elementen wie auch von den B-Elementen. Es ergibt sich dann eine einheitliche Magnetisierungsausrichtung in den beiden Elementgruppen. Dieses Biasfeld hat Folgen sowohl für die Brückenempfindlichkeit wie auch für die Orientierung der leichten Vorzugsachsen $V_a$ bzw. $V_b$. Die Empfindlichkeit ist nämlich bei $H_z \neq 0$ abhängig von dem Meßfeld $H_m$ und ist für sehr kleine $H_m$ gegeben durch die Gleichung (4c) sowie durch die folgenden Beziehungen:

$$\chi_a = M_m / (H_z + H_a^{eff}) \text{ mit } H_a^{eff} = 2(K - 2\pi M_m^2 d_m/B_a)/M_m \tag{5a}$$

$$\chi_b = M_m / (H_z + H_b^{eff}) \text{ mit } H_b^{eff} = 2(K + 2\pi M_m^2 d_m/B_b)/M_m \tag{5b}$$

Aus den Gleichungen (5a), (4c) und (2) ist abzulesen, daß sich die Suszeptibilität $\chi_a$ und die Brückenempfindlichkeit in Abhängigkeit von dem zusätzlichen Biasfeld $H_z$ verringern. Dabei stellt das in Figur 1 angenommene Beispiel mit $H_z$ parallel zu den Vorzugsachsen $V_a$ und $V_b$ nur eine Möglichkeit aus einer Vielfalt von Orientierungsmöglichkeiten von $H_z$ dar.

Gegebenenfalls läßt sich eine Domänenbildung besser mit einem Feld geringerer Stärke unterdrücken, wenn das zusätzliche Biasfeld $H_z$ parallel zur Längsrichtung der einzelnen Sensorelemente ausgerichtet ist. Dies ist jedoch bei dem Figur 1 zugrundegelegten Ausführungsbeispiel einer erfindungsgemäßen Sensoreinrichtung nicht der Fall.

Jedoch ist bei dem Ausführungsbeispiel gemäß der in Figur 2 gezeigten Brückenschaltung ein Aufbau der einzelnen Sensorelemente zugrundegelegt, bei dem die Vorzugsachsen $V_a$ und $V_b$ sowie das zusätzliche Biasfeld $H_z$ parallel zur Längsrichtung aller Elemente stehen. Um eine möglichst große Empfindlichkeit bei kleinen Meßfeldern zu gewährleisten, sind wiederum die Biasschichtmagnetisierungen $M_h$ und das Meßfeld $H_m$ senkrecht zur jeweiligen Vorzugsachse gerichtet. Für die Suszeptibilitäten bei kleinen Meßfeldern $H_m$ gelten nunmehr die folgenden Beziehungen:

$$\chi_a = M_m / (H_z + H_a^{eff}) \text{ mit } H_a^{eff} = 2(K + 2\pi M_m^2 d_m/B_a)/M_m \tag{6a}$$

$$\chi_b = M_m / (H_z + H_b^{eff}) \text{ mit } H_b^{eff} = 2(K + 2\pi M_m^2 d_m/B_b)/M_m \tag{6b}$$

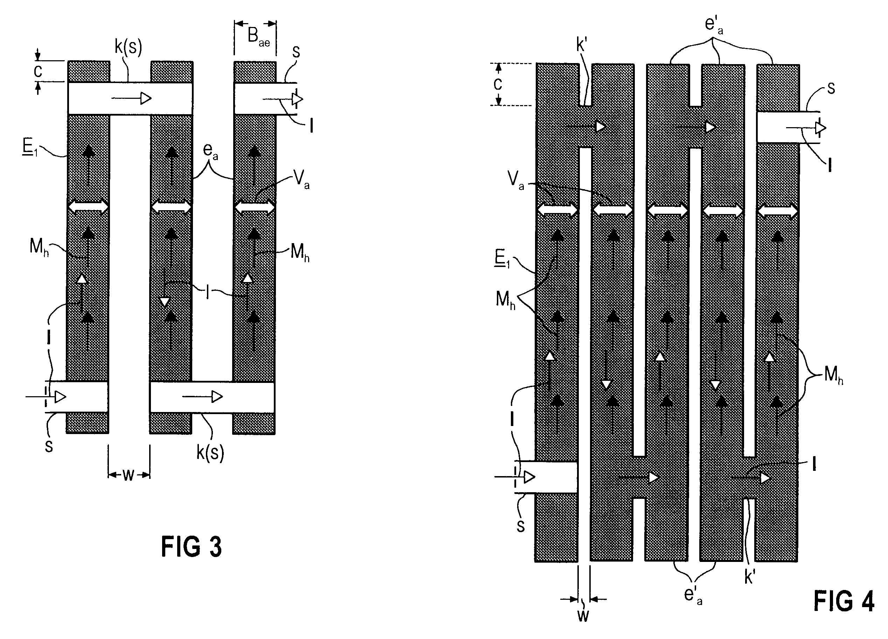

In diesem Fall kann auf die Vorzugsachse verzichtet werden, wenn eine möglichst große Empfindlichkeit erwünscht ist. Dies ist ein Vorteil dieser Konfiguration. Die Brückenempfindlichkeit wird dann vor allem durch den Term "$1/(H_z + 4\pi M_m d_m/B_a)$" bestimmt und ist groß bei verhältnismäßig großer Breite $B_a$. Wie bereits erwähnt, führt ein großes $B_a$ entweder zu großen Abmessungen der Sensorelemente oder zu einem niedrigen Elementwiderstand. In den Figuren 3 und 4 sind zwei Ausführungsformen für großflächige Sensorelemente der Gruppe A jeweils in Aufsicht veranschaulicht, bei denen der Einfluß des Terms "$4\pi M_m d_m/B_a$" auf die Empfindlichkeit verringert ist.

Gemäß Figur 3 setzt sich ein entsprechendes Sensorelement der Gruppe A, beispielsweise das Element $E_1$ der Figur 1, aus mehreren, in Führungsrichtung eines Stromes I langgestreckten, streifenförmigen Teilelementen $e_a$ zusammen. Die gemäß Figur 3 drei Teilelemente $e_a$ haben jeweils eine Länge $L_a$ und eine Breite $B_{ae}$ und sind parallel nebeneinander unter Ausbildung eines gegenseitigen Zwischenraumes der Weite w angeordnet. Sie sind in Stromführungsrichtung gesehen mäanderförmig mittels z.B. unmagnetischer, streifenförmiger Stromleiterbahnen s hintereinandergeschaltet, die Kontaktbrücken k zwischen den einzelnen streifenförmigen Teilelementen $e_a$ bilden. Die Weite w zwischen diesen Teilelementen $e_a$ wird vorteilhaft so klein gewählt, daß die Wechselwirkung zwischen den Einzelelementen zu einer beträchtlichen Abnahme des Terms "$2\pi M_m^2 d_m/B_{ae}$" jedes Teilelementes mit der Breite $B_{ae}$ führt. Wegen der geringen Breite $B_{ae}$ und der nunmehr dreifachen Länge des Stromweges steigt der Widerstand um mindestens einen Faktor 3. Der magnetostatische Beitrag zu der effektiven Anisotropiekonstanten liegt je nach Weite w zwischen "$2\pi M_m^2 d_m/B_{ae}$" und "$2\pi M_m^2 d_m/B_a$", wenn $B_a$ die Gesamtbreite des aus den Teilelementen $e_a$ zusammengesetzten Sensorelementes (z.B. $E_1$) unter Weglassung der Zwischenräume mit der jeweiligen Weite w ist. In erster Näherung läßt sich der magnetostatische Beitrag durch folgenden Ausdruck beschreiben:

$$K_{mag} \cong 2\pi M_m{}^2 d_m \left[ \sum_{n=1}^{(n_{tot}+1)/2} \frac{1}{2(n\text{-}1)(B_{ae}+w)+B_{ae}} - \sum_{n=1}^{(n_{tot}\text{-}1)/2} \frac{1}{2(n\text{-}1)B_{ae}+B_{ae}+2nw} \right] \qquad (7)$$

Dabei ist $n_{tot}$ (ungerade) die Gesamtzahl der Teilelemente $e_a$ pro Element $E_a$.

Gemäß einem konkreten Ausführungsbeispiel eines Elementes $E_a$ entsprechend Figur 3 seien $B_{ae}$ = 15 µm, w = 1,5 µm, $n_{tot}$ = 3. Es ergibt sich so eine effektive Breite $B_{eff}$ von 31,3 µm, die fast in der Mitte zwischen dem Wert für $B_{ae}$ und dem für $B_a$ = 3 * 15 µm liegt (entsprechend ergäbe sich für $n_{tot}$ = 5 eine effektive Breite $B_{eff}$ von 40 µm statt $B_a$ = 5 * 15 µm). Bei gleichbleibender Länge $L_a$ nimmt dann der Widerstand um einen Faktor 9 zu. Unter einer effektiven Breite $B_{eff}$ wird dabei die Breite eines flächigen Sensorelementes mit gleicher Wirkung ohne Zwischenräume der Weite w verstanden.

Wie ferner in Figur 3 angedeutet ist, werden dielektrische Brücken zwischen den einzelnen Teilelementen $e_a$ bildenden streifenartigen Stromleiter s vorteilhaft in einem Abstand c von den Enden der Teilelemente angeordnet. Auf diese Weise sind entmagnetisierende Effekte an den Enden der Teilelemente von der Signalerzeugungsstrecke auszuschließen. Da die Stromleiter s aus unmagnetischem Material bestehen, können auch an diesen Stellen homogene Entmagnetisierungsbedingungen vorgefunden werden.

Figur 4 zeigt eine weitere Ausbildungsmöglichkeit eines aus Teilelementen $e'_a$ aufgebauten Sensorelementes der A-Gruppe nach Figur 1, beispielsweise des Elementes $E_1$. Hier sind Kontaktbrücken k' zwischen benachbarten Teilelementen dadurch realisiert, daß sowohl die Teilelemente als auch die Kontaktbrücken durch entsprechende Strukturierung, beispielsweise mittels Elektronenlithographie, aus einem gemeinsamen flächenhaften Schichtaufbau herausgearbeitet sind. Die Kontaktbrücken k' weisen hier also die gleiche Schichtstruktur wie die Teilelemente $e'_a$ auf. Es lassen sich so sehr kleine Weiten w zwischen den einzelnen Teilelementen $e_a$ erhalten, so daß dann die effektive Breite $B_{eff}$ des gesamten Sensorelementes $E_1$ praktisch gleich groß $B_a$ ist.

Ferner ist es auch möglich, die Kontaktbrücken k oder k' zwischen den streifenartigen Teilelementen $e_a$ oder $e'_a$ ohne beträchtliche Qualitätseinbuße aus einem magnetischen Material herzustellen.

Bei den in den Figuren 1 und 2 veranschaulichten Ausführungsbeispielen von erfindungsgemäßen Sensoreinrichtungen wurde davon ausgegangen, daß deren Brückenschaltungen jeweils mit zwei Gruppen (A und B) von Sensorelementen aufgebaut sind, wobei die Sensorelemente innerhalb jeder Gruppe gleiche Grundflächen aufweisen. Die Folge davon ist, daß an den Meßpunkten der Brückenschaltungen im feldfreien Fall ($H_m$ = 0) praktisch kein Meßsignal $U_m$ auftritt. Eine Sensoreinrichtung nach der Erfindung ist jedoch nicht auf eine derartige Ausgestaltung ihrer Sensorelemente beschränkt. Vielmehr ist es auch möglich, für eine Brückenschaltung nur ein Sensorelement vorzusehen, das von den übrigen drei Sensorelementen mit jeweils gleicher Grundfläche eine davon abweichende Grundfläche besitzt. In diesem Falle wird sich im allgemeinen bei fehlendem äußeren Magnetfeld eine endliche Meßspannung $U_m$ einstellen. Diese Meßspannung kann gegebenenfalls jedoch dadurch eliminiert werden, daß man zumindest eines der Sensorelemente der Brückenschaltung oder insbesondere alle Elemente permanent in einem magnetischen Zusatzfeld anordnet.

Zur Verschaltung der einzelnen Brückenelemente zu einer Brückenschaltung gemäß den Figuren 1 und 2 wird jedes Element mit seinem GMR-Schichtsystem mit wenigstens zwei Kontakten versehen. Diese Kontakte werden entweder beide auf der obersten Meßschicht des entsprechenden magnetfeldempfindlichen Schichtsystems angeordnet, so daß der Strom I im Mittel parallel zu den Schichtebenen fließt (sogenanntes "Current-in-Plane (CIP)-System"); oder es wird jeweils ein Kontakt auf der obersten und auf der untersten Schicht angeordnet, so daß dann der Strom I im Mittel senkrecht zu den Schichtebenen fließt (sogenanntes "Current-Perpendicular-to-Planes (CPP)-System").

Die erfindungsgemäßen Maßnahmen sind auch nicht nur für die vorgehend erwähnten CIP- und CPP-Systeme anwendbar. Ebenso lassen sich Magnetowiderstand-Tunnelsysteme einsetzen.

Statt der für die Ausführungsbeispiele angenommenen Sensorelemente $E_i$ großen magnetoresistiven Effektes mit schichtförmigem Aufbau sind ebensogut auch Typen mit einem sogenannten granularen Aufbau geeignet. Entsprechende Elemente sind beispielsweise aus "Phys. Rev. Lett.", Vol. 71, No. 14, 1993, Seiten 2331 bis 2333 oder Vol. 68, No. 25, 1992, Seiten 3745 bis 3752 bekannt.

Gegebenenfalls lassen sich für erfindungsgemäße Sensoreinrichtungen auch Sensorelemente verwenden, die einen AMR-Effekt zeigen.

**Patentansprüche**

1. Sensoreinrichtung zur Erfassung eines äußeren zumindest weitgehend homogenen Magnetfeldes mit einer Brückenschaltung von magnetoresistiven Sensorelementen mit Dünnschichtaufbau, die in zwei zwischen Anschlußpunkten für einen über die Brückenschaltung zu führenden Strom parallelgeschalteten Brückenzweigen angeordnet sind, **dadurch gekennzeichnet,**

EP 0 730 162 A2

- daß alle Sensorelemente ($E_1$ bis $E_4$) mit demselben Schichtaufbau auf einem gemeinsamen Trägerelement (T) ausgebildet sind,

und

- daß mindestens eines der Sensorelemente ($E_1$, $E_4$) eine gegenüber den anderen Sensorelementen ($E_2$, $E_3$) abweichende Empfindlichkeit bezüglich seines magnetoresistiven Effektes besitzt, indem dieses mindestens eine Sensorelement ($E_1$, $E_4$) mit der abweichenden Empfindlichkeit eine von den anderen Sensorelementen ($E_2$, $E_3$) abweichende Geometrie auf dem Trägerelement (T) aufweist.

2. Sensoreinrichtung nach Anspruch 1, **dadurch gekennzeichnet,** daß die Geometrie der anderen Sensorelemente ($E_2$, $E_3$) jeweils so klein gewählt ist, daß diese Elemente jeweils zumindest annähernd ein ohmsches Widerstandsverhalten zeigen.

3. Sensoreinrichtung nach Anspruch 1 oder 2, **dadurch gekennzeichnet,** daß das mindestens eine Sensorelement ($E_1$, $E_4$) mit der abweichenden Empfindlichkeit gegenüber den anderen Sensorelementen ($E_2$, $E_3$) auf dem Trägerelement (T) eine vergleichsweise größere Grundfläche ($F_a$) einnimmt.

4. Sensoreinrichtung nach Anspruch 3, **dadurch gekennzeichnet,** daß das Verhältnis ($L_i/B_i$) von Länge ($L_i$) zu Breite ($B_i$) aller Sensorelemente ($E_1$ bis $E_4$) zumindest annähernd gleich groß ist.

5. Sensoreinrichtung nach einem der Ansprüche 1 bis 4, **dadurch gekennzeichnet,** daß die Sensorelemente ($E_1$ bis $E_4$) zwei Gruppen (A bzw. B) von Sensorelementen gleicher Geometrie bilden, wobei jede Gruppe in jedem Brükkenzweig ein Sensorelement aufweist.

6. Sensoreinrichtung nach einem der Ansprüche 1 bis 5, **dadurch gekennzeichnet,** daß das mindestens eine Sensorelement ($E_1$, $E_4$) mit der abweichenden Empfindlichkeit einen sehr großen magnetoresistiven Effekt (GMR) zeigt.

7. Sensoreinrichtung nach einem der Ansprüche 1 bis 6, **dadurch gekennzeichnet,** daß die Sensorelemente ($E_1$ bis $E_4$) jeweils ein Schichtpaket aufweisen mit einer magnetfeldempfindlichen Meßschicht und mit mindestens einer von der Meßschicht magnetisch zumindest weitgehend entkoppelten Biasschicht.

8. Sensoreinrichtung nach einem der Ansprüche 1 bis 7, **dadurch gekennzeichnet,** daß alle Sensorelemente ($E_1$ bis $E_4$) mindestens eine Meßschicht mit in die gleiche Richtung weisender magnetischer Vorzugsachse ($V_a$, $V_b$) aufweisen.

9. Sensoreinrichtung nach Anspruch 7 oder 8, **dadurch gekennzeichnet,** daß das mindestens eine Sensorelement ($E_1$, $E_4$) mit der abweichenden Empfindlichkeit eine magnetische Vorzugsachse ($V_a$) seiner mindestens einen Meßschicht aufweist, die quer zur Stromführungsrichtung gerichtet ist (vgl. Figur 1).

10. Sensoreinrichtung nach Anspruch 7 oder 8, **dadurch gekennzeichnet,** daß das mindestens eine Sensorelement ($E_1$, $E_4$) mit der abweichenden Empfindlichkeit eine magnetische Vorzugsachse ($V_a$) seiner mindestens einen Meßschicht aufweist, die parallel zur Stromführungsrichtung gerichtet ist (vgl. Figur 2).

11. Sensoreinrichtung nach einem der Ansprüche 7 bis 10, **dadurch gekennzeichnet,** daß alle Sensorelemente ($E_1$ bis $E_4$) mindestens eine Biasschicht mit einer quer zur Richtung der magnetischen Vorzugsachse ($V_a$; $V_b$) gerichteten Magnetisierung ($M_h$) aufweisen.

12. Sensoreinrichtung nach einem der Ansprüche 1 bis 11, **dadurch gekennzeichnet,** daß das mindestens eine Sensorelement ($E_1$, $E_4$) mit der abweichenden Geometrie aus mehreren streifenförmigen Teilelementen ($e_a$, $e'_a$) zusammengesetzt ist, wobei diese Teilelemente parallel zur Stromführungsrichtung nebeneinander angeordnet und mäanderförmig elektrisch hintereinander geschaltet sind.

13. Sensoreinrichtung nach Anspruch 12, **dadurch gekennzeichnet,** daß die Teilelemente ($e_a$) mittels streifenförmiger, als Kontaktbrücken (k) dienender Stromleiterbahnen (s) aus nicht-magnetischem Material hintereinandergeschaltet sind.

7

14. Sensoreinrichtung nach Anspruch 12, **dadurch gekennzeichnet,** daß die Teilelemente (e'$_a$) und Kontaktbrücken (k') zu deren elektrischer Hintereinanderschaltung denselben Schichtaufbau aufweisen.

15. Sensoreinrichtung nach Anspruch 13 oder 14, **dadurch gekennzeichnet,** daß die Kontaktbrücken (k, k') von den Enden der jeweiligen streifenförmigen Teilelemente (e$_a$, e'$_a$) um einen vorbestimmten Abstand (c) entfernt angeordnet sind.

**FIG 1**

**FIG 2**

FIG 4

FIG 3